# EUROPEAN PATENT APPLICATION

(11) **EP 1 693 890 A1**
(43) Date of publication of application: **23.08.2006**
(21) Application number: 04807125.2
(22) Date of filing: 09.12.2004
(51) Int. Cl.: H01L 21/52, C09J 183/07

(54) **SILICONE ADHESIVE AGENT**

(30) Priority: 10.12.2003 JP 2003411502
(71) Applicant: GE TOSHIBA SILICONES CO., LTD., Minato-ku, Tokyo 106-0032 (JP)
(72) Inventor: TAMURA, Osamu, (JP); HIRAI, Nobuo, (JP)
(74) Representative: Ackroyd, Robert
(86) International application number: PCT/JP2004/018766
(87) International publication number: WO 2005/057647

(57) **Abstract**

A silicone adhesive agent for joining a semiconductor pellet and a member for mounting said pellet, which comprises a addition reaction curing type silicone rubber composition exhibiting a stain onto a glass plate during curing by heating of a contact angle on the glass of 70° or less. The silicone adhesive agent does not lower the wire bondability and also does not lower the adhesion between the surface of a semiconductor pellet or a lead frame and a scaling resin.

## Description

### Technical Field

The present invention relates to a silicone adhesive (die bonding agent) for bonding a semiconductor pellet to a semiconductor pellet-mounting member such as a tub.

### Background Art

A semiconductor device is a structure produced for example by bonding a semiconductor pellet made of silicon to its support i.e. a semiconductor pellet-mounting member (e.g. a tub) via an adhesive (die bonding agent) such as epoxy resin, polyimide resin etc., then bonding the semiconductor pellet electrically to a metallic lead frame to form an integrally formed product, and sealing the product with sealing resin such as epoxy resin, and in consideration of problems such as cracking in the conventional die bonding agent, a semiconductor device having a semiconductor pellet bound via a silicone adhesive to a tub has been proposed (JP-A 61-55300). The elastic silicone rubber in this proposed semiconductor device is intended to relax internal strain resulting from a difference in thermal coefficient of expansion between the semiconductor pellet and the tub.

In the technique in the above-mentioned JP-A 61-55300, however, there is a problem that after a semiconductor pellet is bound via silicone rubber to a tub, the reliability of a semiconductor device is deteriorated due to deterioration in the bondability (wire bondability) between the semiconductor pellet and a bonding wire (e.g. a metallic wire) or between a lead frame and a bonding wire upon connecting the semiconductor pellet to the lead frame via the bonding wire.

To solve the problem, JP-A 61-55300 proposes use of an addition reaction curing silicone rubber composition wherein the content of low-molecular siloxane having a vapor pressure of 10 mmHg or more at 200°C is 500 ppm or less, and JP-A 2002-60719 proposes use of an adhesive silicone rubber wherein the content of cyclic and linear low-molecular non-functional siloxanes having 11 to 50 silicon atoms is 3 wt% or less.

### Disclosure of the Invention

However, the present inventors' investigation revealed that even by the techniques in the above-mentioned JP-A 61-55300 and JP-A 2002-60719, there remains room for improving the reliability of bonding properties.

To solve the problem in the conventional techniques, the obj ect of the present invention is to provide a silicone adhesive not reducing wire bondability and not reducing the adhesion of the surface of a semiconductor pellet and a lead frame to sealing resin.

The present inventors made extensive study for achieving the above-mentioned object, and as a result, they found that a silicone adhesive comprising a specific addition reaction curing silicone rubber composition can be used very effectively as an adhesive for bonding a semiconductor pellet to a member for mounting the pellet, and the present invention was thereby completed.

That is, the present invention relates to a silicone adhesive for bonding a semiconductor pellet to a member for mounting the pellet, which comprises an addition reaction curing silicone rubber composition contaminating, upon curing by heating, a glass plate therewith at a contact angle of 70°C or less to the glass plate.

Further, the present invention relates to a method of bonding a semiconductor pellet to a member for mounting the pellet by a silicone adhesive comprising an addition reaction curing silicone rubber composition contaminating, upon curing by heating, a glass plate therewith at a contact angle of 70°C or less to the glass plate.

Furthermore, the present invention relates to use of an addition reaction curing silicone rubber composition contaminating, upon curing by heating, a glass plate therewith at a contact angle of 70°C or less to the glass plate as a silicone adhesive for bonding a semiconductor pellet to a member for mounting the pellet.

### Detailed Description of the Invention

Hereinafter, the present invention is described in more detail. The present invention relates to a silicone adhesive for bonding a semiconductor pellet to a member for mounting the pellet, which comprises an addition reaction curing silicone rubber composition contaminating, upon curing by heating, a glass plate therewith at a contact angle of 70°C or less to the glass plate. Such an addition-reaction curing silicone rubber composition includes:
an addition reaction curing silicone rubber composition (referred to hereinafter as the present composition 1) comprising:
   (A) organopolysiloxane having, in one molecule, two or more silicon atom-bound alkenyl groups; 100 parts by weight,
   (B) organopolysiloxane having, in one molecule, two or more silicon atom-bound hydrogen atoms, which shows 5 wt% or less loss in weight upon heating at 100°C for 1 hour; an amount enough to supply 0. 5 to 3 silicon atom-bound hydrogen atoms in component
   (B) per alkenyl group in component (A),
   (C) a tackifier having silicon atom-bound alkoxy groups and not having silicon atom-bound hydrogen atoms; 0.1 to 10 parts by weight, and
   (D) a platinum-based catalyst; a catalytic amount, and
an addition reaction curing silicone rubber composition (referred to hereinafter as the present composition 2) comprising:
   (A) organopolysiloxane having, in one molecule, two or more silicon atom-bound alkenyl groups; 100 parts by weight,
   (B) organopolysiloxane having, in one molecule, two or more silicon atom-bound hydrogen atoms, which shows 5 wt% or less loss in weight upon heating at 100°C for 1 hour; an amount enough to supply 0.5 to 3 silicon atom-bound hydrogen atoms in component (B) per alkenyl group in component (A),
   (D) a platinum-based catalyst; a catalytic amount,
   (E) a tackifier; 0.1 to 10 parts by weight and
   (F) an Al or Ti compound; 0.05 to 10 parts by weight.

First, the present composition 1 is described. The component (A) in the present invention, that is, the organopolysiloxane having, in one molecule, two or more silicon atom-bound alkenyl groups, is a base polymer in the composition of the present invention and is represented by the following average formula (1):

R¹ₐSiO_{(4-a)/2} (1)

wherein R¹s are the same as or different from each other and each represents a C1 to C10 unsubstituted or substituted monovalent hydrocarbon group; and a is a positive number of 1 to 3.

The unsubstituted or substituted monovalent hydrocarbon group represented by R¹, which is bound to the silicon atom, includes for example alkyl groups such as a methyl group, ethyl group, propyl group, isopropyl group, butyl group, isobutyl group, tert-butyl group, pentyl group, neopentyl group, hexyl group, cyclohexyl group, octyl group, nonyl group or decyl group, aryl groups such as a phenyl group, tolyl group, xylyl group or naphthyl group, aralkyl groups such as a benzyl group, phenylethyl group or phenylpropyl group, alkenyl groups such as a vinyl group, allyl group, propenyl group, isopropenyl group, butenyl group, hexenyl group, cyclohexenyl group or octenyl group, and groups wherein in the above-mentioned groups, hydrogen atoms are replaced partially or wholly by halogen atoms such as fluorine, bromine and chlorine or by cyano groups, for example a chloromethyl group, chloropropyl group, bromoethyl group, 3,3,3-trifluoropropyl group, 2-cyanoethyl group etc.

In this case, at least two of R¹s should be alkenyl groups (particularly those having preferably 2 to 8 carbon atoms, more preferably 2 to 6 carbon atoms). The content of alkenyl groups is preferably 0.01 to 20 mol%, particularly preferably 0.1 to 10 mol%, in the total silicon atom-bound organic groups, that is, in the monovalent unsubstituted or substituted hydrocarbon groups R¹ in the average formula (1). The alkenyl group may be bound to a silicon atom at the terminus of the molecular chain and/or a silicon atom in the molecular chain. From the viewpoint of the curing rate of the composition, physical properties of a cured product, etc. , the organopolysiloxane used in the present invention is preferably the one having at least an alkenyl group bound to a silicon atom at the terminus of the molecular chain. R¹ other than the alkenyl group is preferably a methyl group, phenyl group or 3,3,3-trifluoropropyl group.

The organopolysiloxane has a structure having a main chain composed usually of diorganosiloxane repeating units with both terminuses each consisting of diorganopolysiloxane having an essentially linear structure (which may be partially branched or cyclic) blocked with a triorganosiloxy group such as trimethylsiloxy group, dimethylphenylsiloxy group, dirnethylhydroxysiloxy group, dimethylvinylsiloxy group or trivinylsiloxy group. The average polymerization degree (weight-average polymerization degree) is preferably 100 to 100, 000, particularly 200 to 10, 000, and the viscosity at 25°C is preferably 100 to 100, 000, 000 cSt (centistokes), particularly 1,000 to 1,000,000 cSt.

The organopolysiloxane as the component (B) is for example an organopolysiloxane showing 5 wt% or less loss in weight upon heating at 100°C for 1 hour after stripping under the heating condition of 100 to 140°C under reduced pressure at 10 mmHg or less. This component acts as a crosslinking agent for the component (A) and has two or more silicon atom-bound hydrogen atoms in one molecule, and its molecular structure may be a linear, branched or cyclic structure.

The organopolysiloxane is blended in an amount enough to supply 0. 5 to 3 silicon atom-bound hydrogen atoms in the component per one alkenyl group in component (A).

The component (B) includes a methyl hydrogen cyclopolysiloxane, a methyl hydrogen siloxane/dimethyl siloxane cyclic copolymer, methyl hydrogen polysiloxane blocked at both terminuses thereof with a trimethylsiloxy group, a dimethyl siloxane/methyl hydrogen siloxane copolymer blocked at both terminus thereof with a trimethylsiloxy group, dimethyl polysiloxane blocked at both terminus thereof with a dimethyl hydrogen siloxy group, a dimethyl siloxane/methyl hydrogen siloxane copolymer blocked at both terminus thereof with a dimethyl hydrogen siloxy group, a methyl hydrogen siloxane/diphenyl siloxane copolymer blocked at both terminus thereof with a trimethylsiloxy group, a methyl hydrogen siloxane/diphenyl siloxane/dimethyl siloxane copolymer blocked at both terminus thereof with a trimethylsiloxy group, a methyl hydrogen siloxane/dimethyl siloxane/diphenyl siloxane copolymer blocked at both terminus thereof with a dimethyl hydrogen siloxy group, a copolymer consisting of (CH₃)₂HSiO_{1/2} unit, (CH₃)₃SiO_{1/2} unit and SiO_{4/2} unit, a copolymer consisting of (CH₃)₂HSiO_{1/2} unit and SiO_{4/2} unit, and a copolymer consisting of (CH₃)₂HSiO_{1/2} unit, SiO_{4/2} unit and (C₆H₅)₃SiO_{1/2} unit.

The component (C) in the present invention is a tackifier having a silicon atom-bound alkoxy group and not having a silicon atom-bound hydrogen atom.

As the third component tackifier, it is preferable to use an organic silicon compound such as organosilane or an organosiloxane oligomer having about 2 to 50 silicon atoms, preferably 4 to 20 silicon atoms, which contains, in the molecule, at least one silicon atom-bound alkoxy group and at least one reactive functional group selected from an alkenyl group, acryl group, methacryl group and epoxy group. This organic silicon compound is used to endow the silicone rubber composition with adhesiveness to a semiconductor chip, an mounting part, a lead frame etc., and a known one may be used insofar as it does not inhibit addition and vulcanization of the silicone rubber composition.

Such organic silicon compound includes alkoxysilane, for example, epoxy functional group-containing alkoxysilane such as γ-glycidoxy propyl trimethoxysilane or β-(3,4-epoxycyclohexyl)ethyl trimethoxysilane, alkenyl group-containing alkoxysilane such as vinyl trimethoxysilane, vinyl triethoxysilane or vinyltri (methoxyethoxy) silane, and acryl group- or methacryl group-containing alkoxy silane such as γ-methacryloxy propyl trimethoxysilane or γ-acryloxy propyl trimethoxysilane.

The component (C) is used in an amount of 0.1 to 10 parts by weight based on 100 parts by weight of the component (A).

As the component (D), the platinum-based catalyst is a catalyst for curing the adhesive in the present invention, and a general known catalyst for addition reaction can be used, and such catalyst can be exemplified by platinum black, solid platinum carried on a carrier such as alumina or silica, chloroplatinic acid, alcohol-modified chloroplatinic acid, chloroplatinic acid/olefin complexes, and platinum/vinyl siloxane complexes. When these catalysts are solid catalysts, it is preferable that before use, they are finely pulverized for improving dispersibility or the particle diameter of the carrier is decreased to increase specific surface area, and chloroplatinic acid or chloroplatinic acid/olefin complexes are used desirably after dissclving them in a solvent such as alcohol, ketone, ether or a hydrocarbon. The amount of the catalyst added may be suitably regulated so as to attain a desired curing rate, and for obtaining an excellent cured product, the amount (in terms of the amount of platinum) of a siloxane-compatible catalyst such as chloroplatinic acid is regulated desirably in the range of 1 to 100 ppm relative to the total amount of the above-mentioned components (A) and (B).

Now, embodiments of the present composition 2 are described.

The components (A), (B) and (D) in the present composition 2 are the same as in the present composition 1.

The present composition 2 uses the tackifier (E) and the Al or Ti compound (F) in place of the component (C) in the present composition 1.

The tackifier as the component (E), unlike the component (C) subject to the limitation "having silicon atom-bound alkoxy groups and not having silicon atom-bound hydrogen atoms", is not limited and can use a wide variety of known tackifiers including the component (C).

However, when the tackifier other than the component (C) is used, combined use of the Al or Ti compound (F) is essential.

The Al compound as the component (F) is obtained by reacting an aluminum alcoholate such as (MeO)₃Al, (EtO)₃Al or (a-PrO)₃Al, an aluminum salt of naphthenic acid, stearic acid, octylic acid or benzoic acid, an aluminum alcoholate and acetoacetates or dialkyl malonates.

The Al compound is exemplified by aluminum chelates such as: 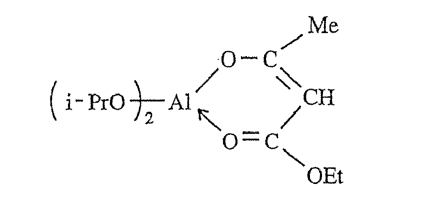 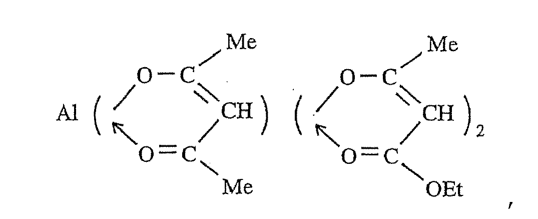 organic acid salts of aluminum oxides, and aluminum acetyl acetonate, among which aluminum chelates and aluminum alcoholates are preferable from the viewpoint of hydrolyzability. Further, bis-ethyl acetoacetate aluminum monoacetyl acetonate and acetoalkoxy aluminum diisopropylate are preferable because they are easily handled liquid.

Examples of the Ti compound as the component (F) include tetraalkoxy titanium compounds such as tetra (n-butoxy) titanium, tetra (i-propoxy) titanium, tetrakis (2-ethylhexoxy) titaniumor tetra (stearoxy) titanium, titanium chelate compounds such as di-i-propoxy-bis(acetyl acetonate) titanium, i-propoxy(2-ethylhexane diolate) titanium, di-i-propoxy-diethyl acetoacetate titanium or hydroxy-bis(lacteto) titanium, i-propyl triisostearoyl titanate, i-propyl-tris(dioctyl pyrophosphate) titanate, tetra-i-propyl-bis(dioctyl phosphite) titanate, tetraoctyl-bis(ditridecyl phosphite) titanate, tetra(2,2-diallyloxymethyl-1-butyl)-bis(ditridecyl) phosphite titanate, bis(dioctyl pyrophosphate) oxyacetate titanate, bis(dioctyl pyrophosphate) ethylene titanate, i-propyl trioctanoyl titanate, and i-propyl dimethacryl-i-stearoyl titanate, among which tetra (n-butoxy) titanate is preferable because the resulting curing organopolysiloxane composition is excellent in storage stability.

The amount of the component (F) blended is 0.05 to 10 parts by weight, preferably 0.1 to 5 parts by weight, relative to 100 parts by weight of the component (A).

A filler may be further blended in the present invention. The filler is used not only for reinforcing the silicone rubber composition to confer necessary rubber strength thereon but also for mainlining necessary viscosity for the bonding operation, and the filler is preferably a reinforcing silica-based filler. The reinforcing silica-based filler includes fumed silica, hydrophobated silica, calcined silica, precipitated silica etc.

The composition of the present invention may be blended, as far as the purpose is not lost, with addition/vulcanization regulators such as acetylene alcohol etc., titanium dioxide, alumina and carbon black.

### Brief Description of Drawing

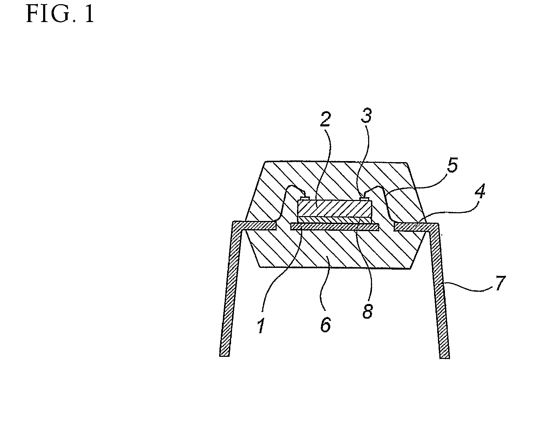

Fig. 1 is a schematic sectional view of a semiconductor device used in evaluation of wire bondability in the Examples.

### Examples

Hereinafter, Examples of the present invention are described. In the following Examples and Comparative Examples, the term "parts" refers to parts by weight.

### Examples 1 to 5 and Comparative Examples 1 to 3

### • Component (A)

760 parts of trimethyl chlorosilane, 141 parts of methyl vinyl dichlorosilane and 146 parts of ethyl o-silicate were co-hydrolyzed in toluene and subjected in a usual manner to acid removal, neutralization and washing with water, then treated with an aqueous potassium hydroxide solution, neutralized with acetic acid, washed with water and dehydrated to give resin having silicon atom-bound vinyl groups and substantially not having silicon atom-bound hydroxyl groups. Organosiloxane having 10 parts of this vinyl group-containing resin incorporated into 90 parts of a, ω-divinyl polydimethyl siloxane having a viscosity of 3,000 cP at 23°C was used as the component (A).

### • Component (B)

Disiloxane represented by MM, cyclic siloxane represented by D₄ and cyclic siloxane represented by D'₄ were polymerized in the presence of a sulfuric acid catalyst and then neutralized to give organosiloxane having silicon atom-bound hydrogen atoms represented by the average formula MD' ₂₃D₁₆M. This siloxane was subjected to stripping treatment for 2 to 4 hours under the heating condition of a temperature of 120°C under reduced pressure at 2 mmHg to give organosiloxane showing the following loss in weight upon heating at 100°C for 1 hour.
4-hour treatment (B)-1 (1.3 wt% loss in weight upon heating)
3-hour treatment (B)-2 (3.8 wt% loss in weight upon heating)
2-hour treatment (B)-3 (6. 5 wt% loss in weight upon heating)
Untreatment (B)-4 (10 wt% loss in weight upon heating)
M, D and D' each represent the following structures:

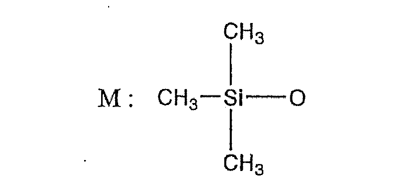

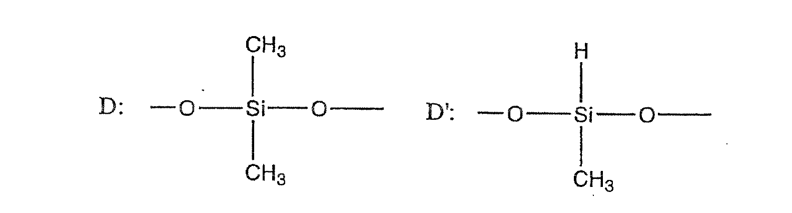

### • Component (C) (which in this Example, includes the component (E))

### (C)-1

A silane compound represented by the following formula:

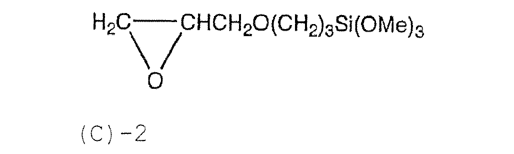

A silane compound represented by the following formula:

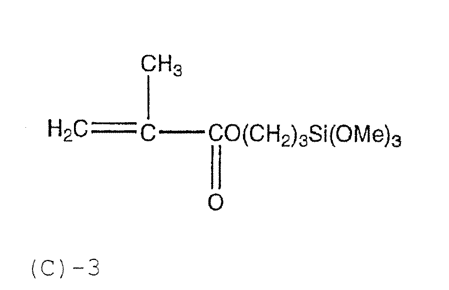

A silane compound represented by the following formula: A reaction product of

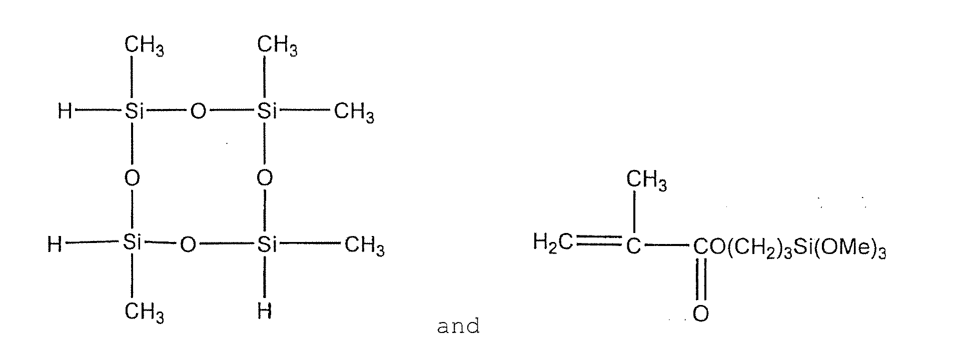

### • Component (D)

Lamorrow's catalyst containing 3.8% platinum

### • Component (F)

### (F)-1

An aluminum chelate represented by the following formula:

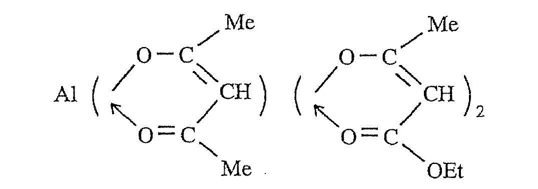

The organosiloxanes and additives shown above were uniformly mixed in the amounts shown in Table 1 to give Compositions 1 to 8. Compositions 6 to 8 are comparative compositions.

In Examples, measurement of contact angle on a glass plate and characteristics of the adhesive was conducted according to the following methods.

### (Measurement of contact angle on a glass plate)

A composition was applied in an amount of 0.0100 to 0.0130 g onto a glass plate of 50×50×1 mm, and a cover glass of 18x18x0.16 mm was placed thereon, and the composition was sandwiched so as to spread over the cover glass. The specimen was placed in a petri dish (inner diameter 70 mm, depth 19 mm), then a lid was put on the dish, and the composition was cured by heating at 150°C for 1 hour. After returning to room temperature, the contact angle thereof to water on five sites, that is, four corners and one central part of the cover glass, and the average contact angle was determined.

### (Evaluation of adhesiveness)

Two copper plates of 80×25×2 mm were arranged so as to be parallel to each other with their long side stacked with each other by 10 mm, and a composition was formed as a layer of 1 mm in thickness between the two copper plates such that the layer was contacted with the 2 opposing stacked faces, then heated at 150°C for 1 hour, and cooled as it was to prepare a specimen. Separately, a specimen was prepared in an analogous manner by using a ceramic (alumina) plate. The specimen thus prepared was fitted into a tensile testing machine and examined for its adhesiveness at a stress rate of 10 mm/min. thereby confirming whether the rupture section was due to cohesive failure or interface peeling.

### (Evaluation of wire bondability)

In the semiconductor for evaluation shown in Fig. 1, adhesive 8 was sandwiched between semiconductor pellet 2 and tub 1, and then heated at 150°C for 1 hour. Aluminum pad 3 and lead frame 4 made of copper were bonded to each other via metallic wire 5 (wire bonding) to prepare an integrally formed specimen. Bonding via metallic wire 4 was carried out using thermosonic contact-bonding. Then, the integrally formed specimen was evaluated by observing the point where the metallic wire 5 and the aluminum pad 3 or the metallic wire 5 and lead frame 4 were connected to each other, and when the metallic wire 5 was raised upon pulling the metallic wire 5, the specimen was evaluated as being inferior in bonding. Ten specimens each having 64 lead frames were prepared, and the number of defects in total 640 pins was counted. In Fig. 1, 6 is an epoxy resin, and 7 is an external lead frame made of copper. The results are shown in Table 1.

**Table 1**

| Composition No. | 1 | 2 | 3 | 4 | 5 | 6 | 7 | 8 |
|---|---|---|---|---|---|---|---|---|
| | Example 1 | Example 2 | Example 3 | Example 4 | Example 5 | Comparative Example 1 | Comparative Example 2 | Comparative Example 3 |
| (A) | 100 | 100 | 100 | 100 | 100 | 100 | 100 | 100 |
| (B)-1 | 5.4 | 5.4 | | 5.4 | 5.4 | | | 5.4 |
| (B)-2 | | | 5.4 | | | | | |
| (B)-3 | | | | | | 5.4 | | |
| (B)-4 | | | | | | | 5.4 | |
| (D) | 0.05 | 0.05 | 0.05 | 0.05 | 0.05 | 0.05 | 0.05 | 0.05 |
| (C)-1 | 2 | | 2 | | 2 | 2 | 2 | |
| (C)-2 | | 2 | | | | | | |
| (C)-3 | | | | 2 | | | | 2 |
| (F) | | | | 0.2 | 0.2 | | | |
| Contact angle (150°Cx1h)° | 66 | 65 | 68 | 66 | 64 | 72 | 74 | 76 |
| Adhesiveness | | | | | | | | |
| Copper plate | Cohesive failure | Cohesive failure | Cohesive failure | Cohesive failure | Cohesive failure | Cohesive failure | Cohesive failure | Cohesive failure |
| Ceramic (alumina) plate | Cohesive failure | Cohesive failure | Cohesive failure | Cohesive failure | Cohesive failure | Cohesive failure | Cohesive failure | Cohesive failure |
| Number of wire bonding defects | 0 | 0 | 0 | 0 | 0 | 28 | 43 | 51 |

## Claims

1. A silicone adhesive for bonding a semiconductor pellet to a member for mounting the pellet, which comprises an addition reaction curing silicone rubber composition contaminating, upon curing by heating, a glass plate therewith at a contact angle of 70°C or less to the glass plate.

2. The silicone adhesive according to claim 1, wherein the addition reaction curing silicone rubber composition comprises:
(A) organopolysiloxane having, in one molecule, two or more silicon atom-bound alkenyl groups; 100 parts by weight,
(B) organopolysiloxane having, in one molecule, two or more silicon atom-bound hydrogen atoms, which shows 5 wt% or less loss in weight upon heating at 100°C for 1 hour; an amount enough to supply 0.5 to 3 silicon atom-bound hydrogen atoms in component
(B) per alkenyl group in component (A),
(C) a tackifier having silicon atom-bound alkoxy groups and not having silicon atom-bound hydrogen atoms; 0.1 to 10 parts by weight, and
(D) a platinum-based catalyst; a catalytic amount.

3. The silicone adhesive according to claim 1, wherein the addition reaction curing silicone rubber composition comprises:
(A) organopolysiloxane having, in one molecule, two or more silicon atom-bound alkenyl groups; 100 parts by weight,
(B) organopolysiloxane having, in one molecule, two or more silicon atom-bound hydrogen atoms, which shows 5 wt% or less loss in weight upon heating at 100°C for 1 hour; an amount enough to supply 0. 5 to 3 silicon atom-bound hydrogen atoms in component (B) per alkenyl group in component (A),
(D) a platinum-based catalyst; a catalytic amount,
(E) a tackifier; 0.1 to 10 parts by weight, and
(F) an Al or Ti compound; 0.05 to 10 parts by weight.

4. A method of bonding a semiconductor pellet to a member for mounting the pellet by a silicone adhesive comprising an addition reaction curing silicone rubber composition contaminating, upon curing by heating, a glass plate therewith at a contact angle of 70°C or less to the glass plate.

5. Use of an addition reaction curing silicone rubber composition contaminating, upon curing by heating, a glass plate therewith at a contact angle of 70°C or less to the glass plate as a silicone adhesive for bonding a semiconductor pellet to a member for mounting the pellet.
